Europäisches Patentamt

European Patent Office

Office européen des brevets

(19)

(11) **EP 1 166 275 B1**

(12) **EUROPÄISCHE PATENTSCHRIFT**

(45) Veröffentlichungstag und Bekanntmachung des Hinweises auf die Patenterteilung:
**03.09.2003   Patentblatt 2003/36**

(21) Anmeldenummer: **00920384.5**

(22) Anmeldetag: **13.03.2000**

(51) Int Cl.$^{7}$: **G11C 11/16**, G11C 7/06

(86) Internationale Anmeldenummer:
**PCT/DE00/00778**

(87) Internationale Veröffentlichungsnummer:
**WO 00/060601 (12.10.2000 Gazette 2000/41)**

(54) **VORRICHTUNG ZUR BEWERTUNG DER ZELLENWIDERSTÄNDE IN EINEM MAGNETORESISTIVEN SPEICHER**

DEVICE FOR WEIGHTING THE CELL RESISTANCES IN A MAGNETORESISTIVE MEMORY

DISPOSITIF POUR PONDERER LES RESISTANCES DE CELLULES DANS UNE MEMOIRE MAGNETORESISTIVE

(84) Benannte Vertragsstaaten:
**DE FR GB IE IT**

(30) Priorität: **30.03.1999  DE 19914488**

(43) Veröffentlichungstag der Anmeldung:
**02.01.2002   Patentblatt 2002/01**

(73) Patentinhaber: **Infineon Technologies AG
81669 München (DE)**

(72) Erfinder:
• **THEWES, Roland
  D-82194 Gröbenzell (DE)**

• **WEBER, Werner
  D-80637 München (DE)**

(74) Vertreter: **Ginzel, Christian et al
Zimmermann & Partner,
Postfach 33 09 20
80069 München (DE)**

(56) Entgegenhaltungen:
**US-A- 5 493 533          US-A- 5 654 566**

Anmerkung: Innerhalb von neun Monaten nach der Bekanntmachung des Hinweises auf die Erteilung des europäischen Patents  kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft eine Vorrichtung zur Bewertung eines magnetisch veränderbaren elektrischen Widerstands einer magnetoresistiven Speicherzelle (MRAM) mit Hilfe eines Referenzwiderstands. Eine solche Speicherzelle weist typischerweise eine weichmagnetische Schicht und eine hartmägnetische Schicht auf, die elektrisch leitend und durch ein Tunneloxid voneinander getrennt sind, wobei die Tunnelwahrscheinlichkeit und damit der elektrische Widerstand von den Polarisierungsrichtungen der beiden Schichten abhängt.

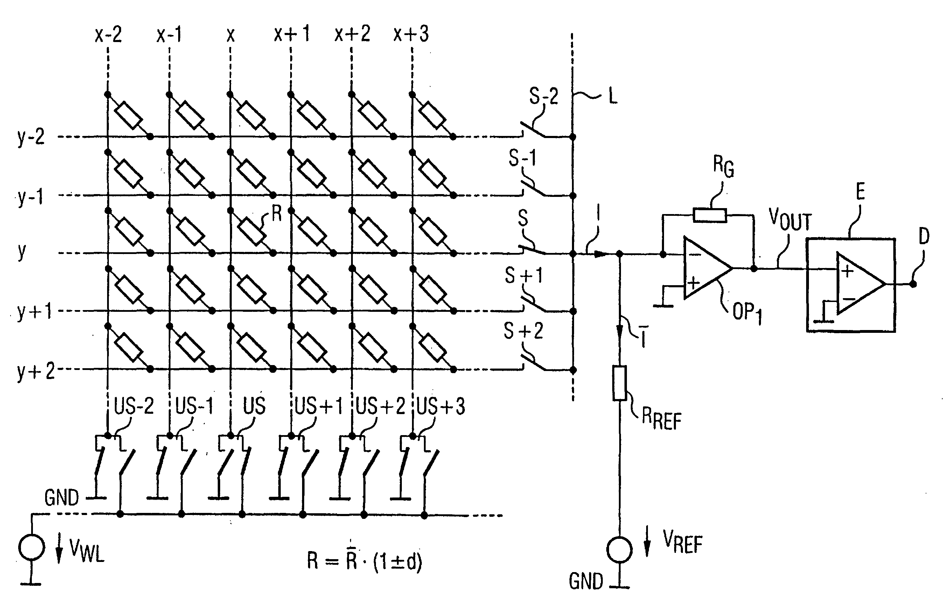

Eine solche Vorrichtung ist aus dem US-Patent 5,173,873, insbesondere aus Figur 4, bekannt, wobei jeweils pro Spalte der Widerstand einer einzigen Referenzzelle herangezogen wird und eine Bewertung hierdurch schnell und mit geringer Verlustleitung erfolgt.

Aufgrund der Fertigungstoleranzen sind die Zellenwiderstände über das gesamte Speicherzellenfeld nicht konstant und es treten für den gleichen Informationszustand nach Durchführung einer Widerstands-Spannungs-Umsetzung durch eine Bewerterschaltung unterschiedliche Ausgangsspannungen auf, die von einer nachgeschalteten Entscheiderschaltung oftmals nicht mehr richtig zugeordnet werden können.

Die der Erfindung zugrunde liegende Aufgabe besteht nun darin, eine Vorrichtung zur Bewertung der Zellenwiderstände in einem magnetoresistiven Speicher anzugeben, bei der hohe, insbesondere für neue Bauelemente mit geringen Spannungspegeln und geringer Verlustleitung kritische, Offset-Spannungen in diesen Bewertungsvorrichtungen beseitigt werden.

Diese Aufgabe wird erfindungsgemäß durch die Merkmale des Patentanspruchs 1 gelöst. Vorteilhafte Ausbildungen der Erfindung ergeben sich aus den Unteransprüchen 2 und 3.

Die Erfindung besteht im wesentlichen darin, daß ein vom jeweiligen Informationszustand der Zelle abhängiger Zellenstrom um einen mittleren Zellenstrom vermindert wird und diese Stromdifferenz in eine entsprechende Ausgangsspannung umgesetzt wird, wobei zur Bildung des mittleren Zellenstromes eine Kombination von Zellwiderständen aus Zellen mit unterschiedlichem Informationsgehalt dienen.

Nachfolgend wird ein bevorzugtes Ausführungsbeispiel der Erfindung anhand der Zeichnung näher erläutert. Die Zeichnung zeigt eine matrizenförmige Anordnung von Bitleitungen y+2...y...y-2 von Wortleitungen x-2...x...x+3, die einen Ausschnitt aus einem Zellenfeld eines magnetoresistiven Speichers darstellen. Zwischen jeder Bitleitung und jeder Wortleitung ist ein magnetoresistiver Widerstand R vorhanden, der üblicherweise auf einem übereinander liegenden und durch ein Tunneloxid getrennten weichmagetischen und einem hartmagnetischen Bereich besteht. Zwischen einer ausgewählten Wortleitung x und einer ausgewählten Bitleitung y liegt der ausgewählte Zellwiderstand R. Die Auswahl bzw. die Adressierung der Wortleitungen erfolgt hier beispielsweise mit Hilfe von Umschaltern US-2...US+3, die der Reihe nach jeweils mit einer der Wortleitungen x-2...x+3 verbunden sind und über die jeweils eine ausgewählte Wortleitung, hier die Wortleitung x, mit einer Wortleitungsspannung $V_{WL}$ und die anderen Wortleitungen mit Bezugspotential GND verbunden werden. Damit nicht alle mit der Wortleitung x verbundenen Zellwiderstände, sondern nur der mit der adressierten Bitleitung y verbundene Zellwiderstand R auf eine gemeinsame Leitung L durchgeschaltet werden, bleiben alle Schalter S-2...S+2 bis auf den Schalter S geöffnet.

Für einen aus einer Mehrzahl von Bitleitungen und Wortleitungen bestehenden Bereich des Zellenfeldes oder aber für das gesamte Zellenfeld ist eine Bewerterschaltung mit einer nachgeschalteten Entscheiderstufe E vorhanden, die aus einer Ausgangsspannung $V_{OUT}$ der Bewerterschaltung entsprechende Datenpegel D erzeugt.

Die eigentliche Bewerterschaltung weist einen Operationsverstärker $OP_1$ auf, dessen Aüsgang die Ausgangsspannung $V_{OUT}$ führt und über einen Rückkoppelwiderstand $R_G$ auf den invertierenden Eingang rückgekoppelt und dessen nichtinvertierender Eingang mit Bezugspotential verbunden ist. Der invertierende Eingang des Operationsverstärkers $OP_1$ ist mit der Sammelleitung L verbunden, wodurch in diesem Beispiel die Wortleitungsspannung $V_{WL}$ über den Umschalter US, den ausgewählten Zellwiderstand R und den geschlossenen Schalter S mit dem invertierenden Eingang verbunden ist und aus der Leitung L ein entsprechender Zellenstrom I fließt. Der Zellenwiderstand R ist von der gespeicherten Information abhängig und kann wie folgt angegeben werden.

$$R = \bar{R} * (1 \pm d),$$

wobei $\bar{R}$ ein mittlerer Widerstand und d eine informationsabhängige relative Widerstandsänderung, die beispielsweise in der Größenordnung von einigen Prozent liegt, bedeuten. Bei der Erfindung wird von dem Strom I ein mittlerer Strom $\bar{I}$ subtrahiert und es gelangt zum invertierenden Eingang des über den Widerstand $R_G$ rückgekoppelten Operationsverstärker $OP_1$ nur eine Stromdifferenz $I - \bar{I}$. Der mittlere Strom $\bar{I}$ wird aus einem Referenzwiderstand $R_{REF}$ und einer Referenzspannung $V_{REF}$ gebildet, wobei die Spannung $V_{REF}$ ein anderes Vorzeichen als die Wortleitungsspannung $V_{WL}$ aufweist. Der Referenzwiderstand $R_{REF}$ und die Referenzspannung $V_{REF}$ müssen so dimensioniert werden, daß bei einem Zellenwiderstand $R = \bar{R}$ und einer Wortleitungsspannung $V_{WL}$ der Strom I gleich $\bar{I}$ ist und damit die Ausgangsspannung $V_{OUT}$ gleich Null ist.

Die Referenzspannung $V_{REF}$ kann dabei vorteilhafterweise mit Hilfe einer üblichen invertierenden Operationsverstärkerschaltung in Abhängigkeit der Wortleitungsspannung $V_{WL}$ aber auch umgekehrt die Wortleitungsspannung $V_{WL}$ auf diese Weise aus einer vorgegebenen Referenzspannung $V_{REF}$ erzeugt werden.

Der Referenzwiderstand $R_{REF}$ sollte vorteilhafterweise aus demselben Material wie Zellenwiderstände bestehen. Bei gleicher Geometrie des Referenzwiderstandes $R_{REF}$ wie die Zellenwiderstände sind nur Widerstände $R=\bar{R} * (1 \pm d)$ und nicht der Mittelwert $\bar{R}$ verfügbar. Hierzu wird im einfachsten Fall ein Zellenwiderstand einer Zelle mit einer gespeicherten logischen Eins und ein Zellenwiderstand einer Zelle mit einer gespeicherten logischen Null in Reihe geschaltet, was einen Referenzwiderstand mit dem Wert $2 * \bar{R}$ liefert und eine entsprechende Referenzspannung $V_{REF}$ erfordert. Durch Parallelschaltung zweier solcher Reihenschaltungen kann der Referenzwiderstand $R_{REF} = \bar{R}$ auf einfache Weise erzeugt werden. Um einen Mittelwert zu erreichen, der für möglichst viele Zellen optimal ist, können weitere solcher Reihenschaltungen parallel geschaltet werden, wodurch sich der Referenzwiderstand und entsprechend auch die hierfür erforderliche Referenzspannung erniedrigt.

**Patentansprüche**

1.  Magnetoresistiver Speicher mit Zellenwiderständen und einer Vorrichtung zur Bewertung der Zellenwiderstände,
    bei dem ein erster Anschluß eines jeweiligen Zellenwiderstandes (R) über Schalter (US) mit einer Wortleitungsspannung ($V_{WL}$) und ein zweiter Anschluß des jeweiligen Zellenwiderstandes mit einem Leitungsknoten (L) über weitere Schalter (S) verbindbar ist,
    bei dem der Leitungsknoten über einen Referenzwiderstand ($R_{REF}$) mit einer Referenzspannungsquelle ($V_{REF}$) verbunden ist, die eine Reduktion eines jeweiligen aus dem Leitungsknoten fließenden Zellenstromes ($\bar{I}$) um einen mittleren Strom ($\bar{I}$) bewirkt, und
    bei dem ein Verstärker ($OP_1$, RG) die Differenz aus dem jeweiligen Zellenstrom und dem mittleren Strom in eine Spannung ($V_{OUT}$) als Bewertungssignal umwandelt,
    wobei der Referenzwiderstand (RREF) aus einer Zusammenschaltung von Zellenwiderständen von Zellen mit unterschiedlichem Informationsgehalt besteht, der zur Bildung des mittleren Stroms ($\bar{I}$) dient.

2.  Speicher nach Anspruch 1,
    bei der der Referenzwiderstand entweder eine einzelne Reihenschaltung von zwei Zellenwiderständen von Zellen mit unterschiedlichem Informationsgehalt oder eine Parallelschaltung solcher Reihenschaltungen aufweist.

3.  Speicher nach einem der vorhergehenden Ansprüche,
    bei der die Referenzspannung ($V_{REF}$) aus der Wortleitungsspannung ($V_{WL}$) oder umgekehrt die Wortleitungsspannung aus der Referenzspannung mit Hilfe einer invertierenden Spannungsverstärkerschaltung gebildet ist.

**Claims**

1.  Magnetoresistive memory having cell resistors and a device for evaluating the cell resistors,
    in which a first terminal of a respective cell resistor (R) can be connected to a word line voltage ($V_{WL}$) via switches (US) and a second terminal of the respective cell resistor can be connected to a line node (L) via further switches (S), in which
    the line node is connected via a reference resistor ($R_{REF}$) to a reference voltage source ($V_{REF}$), which brings about a reduction in a respective cell current ($\bar{I}$), flowing from the line node, by an average current ($\bar{I}$), and
    in which an amplifier ($OP_1$, RG) converts the difference between the respective cell current and the average current into a voltage ($V_{OUT}$) as evaluation signal, the reference resistor (RREF) comprising an interconnection of cell resistors of cells having a different information content which is used to form the average current ($\bar{I}$).

2.  The memory as claimed in claim 1,
    in which the reference resistor has either a single series circuit comprising two cell resistors of cells having a different information content or a parallel circuit comprising such series circuits.

3.  The memory as claimed in one of the preceding claims,
    in which the reference voltage ($V_{REF}$) is formed from the word line voltage ($V_{WL}$) or, conversely, the word line voltage is formed from the reference voltage with the aid of an inverting voltage amplifier circuit.

**Revendications**

1.  Mémoire magnétorésistive ayant des résistances de cellule et un dispositif d'évaluation des résistances de cellule,
    dans laquelle une première borne d'une résistance (R) respective de cellule peut être reliée par des commutateurs (US) à une tension ($V_{WL}$) de ligne de mot et une deuxième borne de la résistance respective de cellule à un noeud (L) de ligne par d'autres commutateurs (S),
    dans laquelle le noeud de ligne est relié par une résistance ($R_{REF}$) de référence à une source ($V_{REF}$)

de tension de référence qui provoque une réduction d'un courant ($\bar{I}$) de cellule respectif sortant d'un noeud de ligne d'un courant ($\bar{I}$) moyen et,
dans laquelle un amplificateur ($OP_1$), RG) transforme la différence entre le courant respectif de cellule et le courant moyen en une tension ($V_{OUT}$) servant de signal d'évaluation,
la résistance (RREF) de référence étant constituée d'une interconnection de résistances de cellule ayant un contenu informatif différent qui sert à former le courant ($\bar{I}$).

2. Mémoire suivant la revendication 1,
dans laquelle la résistance de référence comporte soit un circuit série de deux résistances de cellule ayant un contenu informatif différent, soit un circuit parallèle de circuits série de ce genre.

3. Mémoire suivant l'une des revendications précédentes dans laquelle la tension ($V_{REF}$) de référence est formée à partir de la tension ($V_{WL}$) de ligne de mot ou inversement la tension de ligne de mot est formée à partir de la tension de référence à l'aide d'un circuit amplificateur de tension inverseur.